(19) Europäisches Patentamt
European Patent Office
Office européen des brevets

(11) EP 3 099 146 B1

(12) **EUROPEAN PATENT SPECIFICATION**

(45) Date of publication and mention of the grant of the patent:
**04.11.2020 Bulletin 2020/45**

(21) Application number: **15169397.5**

(22) Date of filing: **27.05.2015**

(51) Int Cl.:
***H05K 1/09*** *(2006.01)*
***C09D 11/104*** *(2014.01)*
***C08G 63/12*** *(2006.01)*
*H05K 3/12* *(2006.01)*
***C09D 11/52*** *(2014.01)*
***C09D 127/08*** *(2006.01)*
***H01B 1/22*** *(2006.01)*
*C08K 3/08* *(2006.01)*

(54) **METHOD OF PREPARING A SILVER LAYER OR PATTERN COMPRISING A STEP OF APPLYING A SILVER NANOPARTICLE DISPERSION**

VERFAHREN ZUR VORBEREITUNG EINER SILBERNEN SCHICHT ODER EINES MUSTERS MIT EINER SILBERNANOPARTIKEL-DISPERSION

PROCÉDÉ DE PRÉPARATION D'UNE COUCHE OU D'UNE STRUCTURE D'ARGENT COMPRENANT UNE ÉTAPE D'APPLICATION DE DISPERSION DE NANOPARTICULES D'ARGENT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**30.11.2016 Bulletin 2016/48**

(73) Proprietor: **AGFA-GEVAERT**
**2640 Mortsel (BE)**

(72) Inventors:
- **BOLLEN, Dirk**
**2640 Mortsel (BE)**
- **VRIAMONT, Nicolas**
**2640 Mortsel (BE)**
- **VAN AERT, Hubertus**
**2640 Mortsel (BE)**

(74) Representative: **Viaene, Kris**
**AGFA NV**
**Intellectual Property Department**
**Septestraat 27**
**2640 Mortsel (BE)**

(56) References cited:
**EP-A1- 2 746 353**
**US-A- 4 592 961**
**US-A1- 2004 144 958**
**US-A1- 2012 168 684**
**US-A1- 2014 005 332**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 3 099 146 B1

## Description

### Field of the Invention

The present invention relates to metallic nanoparticle dispersions, for example nanosilver dispersions, and to conductive inks and pastes prepared therefrom. The invention also relates to a method of preparing the metallic nanoparticle dispersion and to conductive layers or patterns formed from the metallic nanoparticle dispersion at moderate curing conditions.

### Background of the Invention

The interest in metallic printing or coating fluids comprising metallic nanoparticles has increased during the last decades due to their unique properties when compared to the bulk properties of a given metal. For example, the melting point of metallic nanoparticles decreases with decreasing particle size making them of interest for printed electronics, electrochemical, optical, magnetic and biological applications.

The production of stable and concentrated metallic printing or coating fluids, which can be printed, for example by inkjet printing, or coated at high speed is of great interest as it enables the preparation of electronic devices at low costs.

Metallic printing or coating fluids are typically a metallic nanoparticle dispersion comprising metallic nanoparticles and a dispersion medium. Such metallic nanoparticle dispersions can be directly used as a printing or coating fluid. However, additional ingredients are often added to the metallic nanoparticle dispersion to optimize the properties of the resulting metallic printing or coating fluids.

The preparation of metallic nanoparticles may be carried out in water or organic solvents by the so-called polyol synthesis as disclosed in for example 'Approaches to the synthesis and Characterization of Spherical and Anisotropic Silver Nanomaterials', Metallic Nanomaterials Vol.1., Edited by Challa S.S.R.Kumar, Wiley-VGH Verlag GmbH&Co.KGaA, Weinheim, by a derivative of the polyol synthesis methodology or by an in-situ reduction of metallic salts in the presence of various reducing agents. Such methods are disclosed in for example US2010143591, US2009142482, US20060264518, EP-A 2147733, EP-A 2139007, EP-A 803551, EP-A 2012952, EP-A 2030706, EP-A 1683592, EP-A 166617, EP-A 2119747, EP-A 2087490, EP-A 2010314, WO2008/151066, WO2006/076603, WO2009/152388, WO2009/157393.

A polymeric dispersant is often used in the preparation of the metallic nanoparticles to obtain stable metallic printing or coating fluids. The polyol synthesis to prepare silver nanoparticles referred to above is typically carried out in the presence of polyvinylpyrrolidone (PVP). Non-stable metallic nanoparticle dispersions may lead to irreversible phase separation causing among others clogging of coating or print heads. Agglomeration of the metallic nanoparticles may also result in a decrease of the conductivity.

Polymeric dispersants typically contain in one part of the molecule so-called anchor groups, which adsorb onto the metallic particles to be dispersed. In another part of the molecule, polymeric dispersants have polymer chains compatible with the dispersion medium and all the ingredients present in the final printing or coating fluids.

Polymeric dispersants are typically homo- or copolymers prepared from acrylic acid, methacrylic acid, vinyl pyrrolidinone, vinyl butyral, vinyl acetate or vinyl alcohol monomers.

Typically, after applying the metallic printing or coating fluids on a substrate, a sintering step, also referred to as curing step, at elevated temperatures is carried out to induce/enhance the conductivity of the applied patterns of layers. The organic components of the metallic printing or coating fluids, for example the polymeric dispersants, may reduce the sintering efficiency and thus the conductivity of the applied patterns of layers. For this reason, higher sintering temperatures and longer sintering times are often required to decompose the organic components.

Typical polymeric dispersants, such as those described above, are characterized by a full decomposition temperature of at least 350°C. Therefore, the layers or patterns coated or printed with metallic printing or coating fluids comprising such polymeric dispersants typically require a sintering step at elevated temperatures to be sure that most of the polymeric dispersants are decomposed.

Such high sintering temperatures are not compatible with common polymer foils, such as polyethylene terephthalate (PET) or polycarbonate, which have relatively low glass transition temperatures. This restricts the choice to more expensive polymers such as polyimide.

There is thus an interest in lowering the sintering temperatures needed to obtain conductive layers or patterns.

EP-A 2468827 discloses polymeric dispersants having 95 wt% decomposition at a temperature below 300°C, as measured by Thermal Gravimetric Analysis. By using metallic printing or coating fluids comprising such polymeric dispersants, the sintering temperature and time could be reduced. In EP-A2608218 and EP-A 2608217 a so called sintering additive is used in combination with a polymeric dispersant of EP-A 2468827 to further lower the sintering temperature.

EP-A 2671927 discloses a metallic nanoparticle dispersion comprising a specific dispersion medium, for example 2-pyrrolidone, resulting in a more stable dispersion without using a polymeric dispersant.

EP-A 2781562 discloses a method of preparing metallic nanoparticle dispersions in the presence of a specific dispersion medium, for example 2-pyrrolidone, and a carboxylic acid.

A problem associated with conductive inks is often their poor adhesion.

EP1860163 discloses an electrically conductive ink comprising an electrically conductive material and a vinyl chloride/vinylacetate/hydroxyalkyl(meth)acrylate copolymer resin. The ink has good adhesion to various base materials such as paper and various plastic films.

WO2004/069941 discloses a conductive ink composition for deposition onto a substrate comprising a mixture of (a) a reactive organic medium, (b) metal flake of powder, and (c) an adhesion promoting additive. The adhesion promoting additive may be a polymer selected from polyvinylidene chloride, polyvinylchloride, polyethylene vinyl chloride, polyester, copolymers thereof, or a primary diamine.

WO2015/023370 discloses a composition comprising stabilized submicron silver particles, a thermoplastic resin and optionally an organic diluent. The thermoplastic resin may be vinyl copolymer comprising among others vinylidene chloride, vinyl chloride, acrylonitrile or alkyl acrylate.

US 2004/144958 discloses conductive ink compositions into which adhesion promoting compounds are incorporated to improve adhesion of the ink compositions to various substrates in the manufacture of electrical conductors.

EP 2 746 353 discloses the use of an acidic polyester as an adhesion promoter in a coating composition.

As nanosilver ink is typically used in combination with different substrates, there is still a need to further improve the adhesion of nanosilver inks towards various substrates.

## Summary of the invention

It is an object of the present invention to provide a stable metallic nanoparticle dispersion wherewith highly conductive coatings or patterns can be obtained having an improved adhesion towards various substrates. This object is realized by the method of preparing a silver layer or pattern as defined in claim 1.

Further advantages and embodiments of the present invention will become apparent from the following description and the dependent claims.

## Detailed description of the invention

### Definitions

The terms polymeric support and foil, as used herein, mean a self-supporting polymer-based sheet, which may be associated with one or more adhesion layers, e.g. subbing layers. Supports and foils are usually manufactured through extrusion.

The term layer as used herein, is considered not to be self-supporting and is manufactured by coating or spraying it on a (polymeric) support or foil.

PET is an abbreviation for polyethylene terephthalate.

The term alkyl means all variants possible for each number of carbon atoms in the alkyl group i.e. methyl, ethyl, for three carbon atoms: n-propyl and isopropyl; for four carbon atoms: n-butyl, isobutyl and tertiary-butyl; for five carbon atoms: n-pentyl, 1,1-dimethyl-propyl, 2,2-dimethylpropyl and 2-methyl-butyl *etc.*

Unless otherwise specified a substituted or unsubstituted alkyl group is preferably a $C_1$ to $C_6$-alkyl group.

Unless otherwise specified a substituted or unsubstituted alkenyl group is preferably a $C_2$ to $C_6$-alkenyl group.

Unless otherwise specified a substituted or unsubstituted alkynyl group is preferably a $C_2$ to $C_6$-alkynyl group.

Unless otherwise specified a substituted or unsubstituted aralkyl group is preferably a phenyl group or a naphthyl group including one, two, three or more $C_1$ to $C_6$-alkyl groups.

Unless otherwise specified a substituted or unsubstituted alkaryl group is preferably a $C_1$ to $C_6$-alkyl group including an aryl group, preferably a phenyl group or naphthyl group.

Unless otherwise specified a substituted or unsubstituted aryl group is preferably a substituted or unsubstituted phenyl group or naphthyl group.

A cyclic group includes at least one ring structure and may be a monocyclic- or polycyclic group, meaning one or more rings fused together.

A heterocyclic group is a cyclic group that has atoms of at least two different elements as members of its ring(s).The counterparts of heterocyclic groups are homocyclic groups, the ring structures of which are made of carbon only. Unless otherwise specified a substituted or unsubstituted heterocyclic group is preferably a five- or six-membered ring substituted by one, two, three or four heteroatoms, preferably selected from oxygen atoms, nitrogen atoms, sulphur atoms, selenium atoms or combinations thereof.

An alicyclic group is a non-aromatic homocyclic group wherein the ring atoms consist of carbon atoms.

The term heteroaryl group means a monocyclic- or polycyclic aromatic ring comprising carbon atoms and one or more heteroatoms in the ring structure, preferably, 1 to 4 heteroatoms, independently selected from nitrogen, oxygen, selenium and sulphur. Preferred examples of heteroaryl groups include, but are not limited to, pyridinyl, pyridazinyl, pyrimidyl, pyrazyl, triazinyl, pyrrolyl, pyrazolyl, imidazolyl, (1,2,3,)- and (1,2,4)-triazolyl, pyrazinyl, pyrimidinyl, tetrazolyl, furyl, thienyl, isoxazolyl, thiazolyl, isoxazolyl, and oxazolyl. A heteroaryl group can be unsubstituted or substituted with one, two or more suitable substituents. Preferably, a heteroaryl group is a monocyclic ring, wherein the ring comprises 1 to 5 carbon atoms and 1 to 4 heteroatoms.
The term substituted, in e.g. substituted alkyl group means that the alkyl group may be substituted by other atoms than the atoms normally present in such a group, i.e. carbon and hydrogen. For example, a substituted alkyl group may include a halogen atom or a thiol group. An unsubstituted alkyl group contains only carbon and hydrogen atoms.
Unless otherwise specified a substituted alkyl group, a substituted alkenyl group, a substituted alkynyl group, a substituted aralkyl group, a substituted alkaryl group, a substituted aryl, a substituted heteroaryl and a substituted heterocyclic group are preferably substituted by one or more substituents selected from the group consisting of methyl, ethyl, n-propyl, isopropyl, n-butyl, 1-isobutyl, 2-isobutyl and tertiary-butyl, ester, amide, ether, thioether, ketone, aldehyde, sulfoxide, sulfone, sulfonate ester, sulphonamide, -Cl, -Br, -I, -OH, -SH, -CN and $-NO_2$.

## The metallic nanoparticle dispersion

In the method of the invention the metallic nanoparticle dispersion is a silver nanoparticle dispersion comprising silver nanoparticles, a liquid carrier and an adhesion promoting compound, characterized in that the adhesion promoting compound is an acidic polyester.
The metallic nanoparticle dispersion may further comprise a binder and other additives to further optimize its properties.

### Adhesion promoting compound

The metallic nanoparticle dispersion comprises an acidic polyester as adhesion promoting compound. It has been observed that metallic nanoparticle dispersions comprising an acidic polyester are characterized by an improved adhesion, especially on ITO (Indium Thin Oxide) substrates.
The amount of the acidic polyester is preferably between 0.01 and 10 wt%, more preferably between 0.05 and 5 wt%, most preferably between 0.1 and 1.0 wt %, relative to the total amount of the metallic nanoparticle dispersion.
The acidic polyester is typically a copolymer with acidic groups having an acid value from 15 up to 150 mg KOH/g. Examples of commercially available acidic polyesters include BYK-4510 (commercially available from Byk Altana), PLUSOLIT H-PD (commercially available from Mäder) or BORCHI GEN HMP-F (commercially available from OMG Borchers).
The acidic polyester is typically a polycondensate of a polyol and a polycarboxylic acid. The polyol and polycarboxylic acid are combined in desired proportions and chemically reacted using standard esterification (condensation) procedures to provide a polyester having both hydroxyl and carboxylic acid groups in the polyester resin. A triol is typically used to provide a branched polyester.
Examples of suitable polycarboxylic acids or anhydrides include, but are not limited to, maleic anhydride, maleic acid, fumaric acid, itaconic acid, phthalic acid, phthalic anhydride, isophthalic acid, trimellitic anhydride, terephthalic acid, naphthalene dicarboxylic acid, adipic acid, azelaic acid, succinic acid, sebacic acid and various mixtures thereof.
Examples of suitable diols, triols and polyols include, but are not limited to, ethylene glycol, propylene glycol, 1,3-propanediol, glycerol, diethylene glycol, dipropylene glycol, triethylene glycol, trimethylolpropane, trimethylolethane, tri propylene glycol, neopentyl glycol, pentaerythritol, 1,4- butanediol, trimethylol propane, hexylene glycol, cyclohexane dimethanol, and polyethylene or polypropylene glycol.
A preferred polyol is trimethylolpropane, a preferred polycarboxylic acid is adipic acid.
The acidic polyesters may be neutralized to optimize the solubility in the liquid carrier of the metallic nanoparticle dispersion. Neutralization may be carried out with amines, such as for example dimethylethanolamine.
Other preferred acidic polyesters are the reaction product of

(a) a polyester having a Molecular Weight (Mn) of 2000 to 10 000, a hydroxyl number of 20 to 75, and an acid value of 15 to 25, the polyester being a condensate of:

  (i) a polyol component comprising a mixture of diols and triols,
  (ii) a polyacid component comprising an alpha, beta-ethylenically unsaturated polycarboxylic acid, and

(b) a phosphorus acid.

Further examples of phosphatised polyesters are disclosed in WO2012/162301.

Binder

The metallic nanoparticle dispersion preferably comprises as binder a vinylidene chloride copolymer comprising 90 wt % or less of vinylidene chloride based on the total weight of the binder. When the amount of vinylidene chloride is above 90 wt % based on the total weight of the binder, the crystallinity of the binder becomes too high resulting in a low solubility in the liquid carrier. Copolymerizaton of vinylidene chloride with further monomers renders the copolymer more amorphous and thus more soluble in the liquid carrier.

The vinylidene chloride copolymer preferably comprises a further monomer selected from the group consisting of vinyl chloride, alkyl acrylate, alkyl methacrylate, vinylether, vinylacetate, vinyl alcohol, acrylonitrile, methacrylonitrile, maleic acid, maleic anhydride, itaconic acid, itaconic acid anhydride, and crotonic acid.

Suitable vinylidene chloride copolymers include: the copolymer of vinylidene chloride, N-tert.-butylacrylamide, n-butyl acrylate, and N-vinyl pyrrolidone (e.g.70:23:3:4), the copolymer of vinylidene chloride, N-tert.-butylacrylamide, n-butyl acrylate, and itaconic acid (e.g. 70:21:5:2), the copolymer of vinylidene chloride, N-tert.-butylacrylamide, and itaconic acid (e.g. 88:10:2), the copolymer of vinylidene chloride, n-butylmaleimide, and itaconic acid (e.g. 90:8:2), the copolymer of vinyl chloride, vinylidene chloride, and methacrylic acid (e.g. 65:30:5), the copolymer of vinylidene chloride, vinyl chloride, and itaconic acid (e.g. 70:26:4), the copolymer of vinyl chloride, n-butyl acrylate, and itaconic acid (e.g. 66:30:4), the copolymer of vinylidene chloride, n-butyl acrylate, and itaconic acid (e.g. 80:18:2), the copolymer of vinylidene chloride, methyl acrylate, and itaconic acid (e.g.90:8:2), the copolymer of vinyl chloride, vinylidene chloride, N-tert.-butylacrylamide, and itaconic acid (e.g. 50:30:18:2). All the ratios given between brackets in the above-mentioned copolymers are ratios by weight.

Derivatives of maleic acid or maleic acid anhydride, such as for example the monomers according to Formulae I and II, may also be used as further monomer of the vinylidene chloride copolymer.

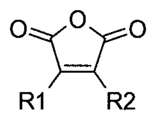

Formula I

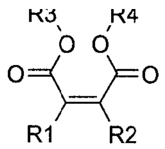

Formula II

wherein R1 to R4 represent a hydrogen atom, an optionally substituted alkyl group containing from 1 to 5 carbon atoms, or an optionally substituted alkenyl group containing from 1 to 5 carbon atoms.

Deriviates of succinic acid or succinic acid anhydride, such as for example the monomers according to Formulae III to VI, may also be used as further monomer of the vinylidene chloride copolymer.

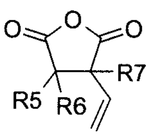

Formula III

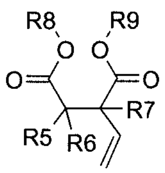

Formula IV

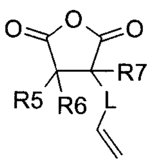

Formula V

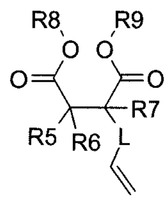

Formula VI

wherein R5 to R9 represent a hydrogen atom, an optionally substituted alkyl group containing from 1 to 5 carbon atoms, or an optionally substituted alkenyl group containing from 1 to 5 carbon atoms;
L represents a linking group selected from the group consisting of an alkylene group containing from 1 to 5 carbon atoms, a polyethylene glycol containing up to 5 ethylene glycol units, or a polypropylene glycol containing up to 5 propylene glycol units.

A preferred monomer according to Formula III is 3-ethenyloxolane-2,5-dione; preferred monomers according to Formula IV are 2-ethenylbutanedioic acid and 1,4-dimethyl 2-ethenylbutanedioate.

The vinylidene chloride copolymer more preferably comprises a further monomer selected from the group consisting of vinyl chloride, acrylonitrile, maleci acid, maleic anhydride and an alkyl acrylate.

The vinylidene chloride copolymer most preferably comprises from 40 to 90 wt % of vinylidene chloride, from 0.5 to 50 wt % of vinyl chloride and from 0.5 to 5 wt % of acrylonitrile.

The alkyl acrylate and alkyl methacrylate referred to above is preferably a C1-C10 alkyl acrylate or methacrylate. Particular preferred alkyl acrylates or alkyl methacrylates are methyl and butyl acrylate or methyl and butyl methacrylate.

A preferred example of a vinylidene chloride copolymer that may be used in the metallic nanoparticle dispersion according to the present invention is IXAN® SGA-1, commercially available from Solvay.

Other vinylidene copolymers that may be used are IXAN® PNE613, IXAN®PV910, IXAN®PV919, IXAN®PVS801, IXAN®PVS815, IXAN®PVS100 or IXAN®PV708, all commercially available from Solvay; F310, F216, R222B or R204, all available from Asahi Kasei Chemicals.

Water based vinylidene copolymers may also be used in the present invention. Examples of such copolymers are Daran® 8730, Daran®8550, Daran®SL112, Daran®SL143, Daran®SL159 or Daran®8100, all commercially available from Owensboro Specialty Polymers; Diofan®193D, Diofan®P520, Diofan®P530 all commercially available from Solvay.

The amount of binder in the metallic nanoparticle dispersion is preferably between 0.1 and 15 wt %, more preferably between 0.2 and 7.5 wt%, most preferably between 0.25 and 5 wt%, particularly preferred between 0.5 and 3.0 wt%, relative to the total weight of the dispersion. When the amount of binder is too high, for example above 15 wt% relative to the total weight of the dispersion, the conductivity of the metallic nanoparticle dispersion tends to decrease. When the amount of binder is too low, for example less than 0.1 wt% relative to the total weight of the dispersion, no improvement in adhesion may be observed.

## Metallic nanoparticles

The metallic nanoparticle dispersion of the present invention comprises silver nanoparticles.

The metallic nanoparticles comprise one or more metals in elemental or alloy form. The metal is preferably selected from the group consisting of silver, gold, copper, nickel, cobalt, molybdenum, palladium, platinum, tin, zinc, titanium, chromium, tantalum, tungsten, iron, rhodium, iridium, ruthenium, osmium, aluminium and lead. Metallic nanoparticles based on silver, copper, molybdenum, aluminium, gold, copper, or a combination thereof, are particularly preferred. Most preferred are metallic nanoparticles based on silver.

The term " nanoparticles" refers to dispersed particles having an average particle size or average particle diameter of less than 100 nm, preferably less than 50 nm, more preferably less than 30 nm, most preferably less than 20 nm. The average particle diameter referred to is determined with Transmission Electron Microscopy (TEM). A metallic nanoparticle dispersion, such as for example a silver ink, may comprise primary particles, and secondary particles. The latter may be aggregated primary particles. The particle diameter referred to above is the particle diameter of the primary particles.

The metallic nanoparticle dispersion preferably comprises at least 5 wt %, more preferably at least 10 wt %, most preferably at least 15 wt %, particularly preferred at least 20 wt % of metallic nanoparticles, relative to the total weight of the dispersion.

## Liquid Carrier

The metallic nanoparticle dispersion comprises a liquid carrier.

The liquid carrier is preferably an organic solvent. The organic solvent may be selected from alcohols, aromatic hydrocarbons, ketones, esters, aliphatic hydrocarbons, dimethylsulfoxide (DMSO), higher fatty acids, carbitols, cellosolves, and higher fatty acid esters.

Suitable alcohols include methanol, ethanol, propanol, 1-butanol, 1-pentanol, 2-butanol, t-butanol.

Suitable aromatic hydrocarbons include toluene and xylene.

Suitable ketones include methyl ethyl ketone, methyl isobutyl ketone, 2,4-pentanedione and hexa-fluoroacetone.

Also glycol, glycolethers, N,N-dimethyl- acetamide, N,N-dimethylformamide may be used.

A mixture of organic solvents may be used to optimize the properties of the metallic nanoparticle dispersion.

Preferred organic solvents are high boiling solvents. High boiling organic solvents referred to herein are solvents which have a boiling point that is higher than the boiling point of water (> 100°C).

Preferred high boiling solvents are shown in the following table.

| Chemical formula | Chemical name | Bp (°C) |
|---|---|---|
| 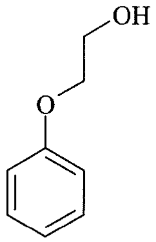 | 2-fenoxy ethanol (ethylene glycol monophenylether) | 247 |
| 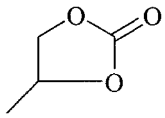 | 4-methyl-1,3-dioxolan-2-one (propylene carbonate) | 242 |
| 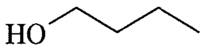 | n-butanol | 117 |
| 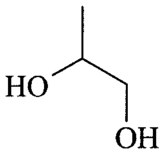 | 1,2-propanediol | 211-217 |
| 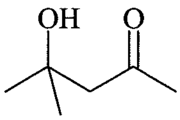 | 4-hydroxy-4-methylpentan-2-one (diaceton alcohol) | 168 |
| 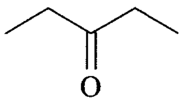 | Pentan-3-one (diethyl ketone) | 102 |
| 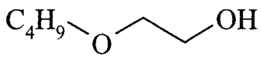 | 2-Butoxyethanol (Ethylene glycol monobutyl ether) | 171 |
| 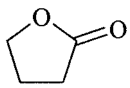 | Dihydrofuran-2(3H)-one (Gamma-butyrolacton) | 204 |
| 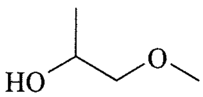 | 1-methoxy-2-propanol (propylene glycol monomethyl ether | 120 |
| 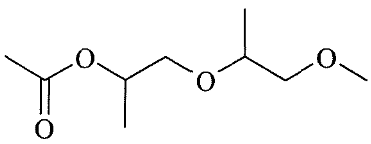 | Dowanol DPMA (Dipropyleenglycol methyl ether acetate) | 209 |
| 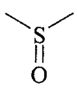 | dimethylsulfoxide | 189 |
| 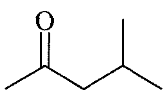 | Methyl isobutyl ketone | 119 |

(continued)

| Chemical formula | Chemical name | Bp (°C) |
|---|---|---|
| 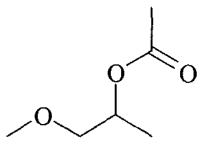 | Propylene glycol mono methyl ether acetate | 146 |

Particularly preferred high boiling solvents used in conductive inkjet inks are 2-phenoxy-ethanol, propyleencarbonate, n-butanol, gamma-butyro-lactone, and mixtures thereof.

Particularly preferred high boiling solvents used in conductive screen printing inks are dimethylsulfoxide, 2-Butoxyethanol, dipropylene glycol methyl ether acetate, and mixtures thereof.

Particularly preferred high boiling solvents used in conductive flexo and gravure printing inks are methyl isobutyl ketone, 2-Butoxy-ethanol, propylene glycol mono methyl ether acetate, and mixtures thereof.

The liquid carrier may also comprise solvents which are used in the preparation method of the nanoparticles, such as those used in the methods disclosed in EP-A 2671927 and EP-A 2781562, for example 2-pyrrolidone.

The amount of the liquid carrier depends on the desired viscosity of the printing or coating fluid. The amount of the liquid carrier is preferably less than 95 wt%, more preferably less than 90 wt%, most preferably less than 85 wt% relative to the total weight of the metallic nanoparticle dispersion.

Surfactants

The metallic nanoparticle dispersion preferably comprises a surfactant to optimize the wetting properties of the dispersion.

The amount of the surfactants is preferably between 0.01 and 10 wt%, more preferably between 0.05 and 5 wt%, most preferably between 0.1 and 1.0 wt %, relative to the total amount of the metallic nanoparticle dispersion.

Dispersion-stabilizing compound (DSC)

The metallic nanoparticle dispersion according to the present invention may comprise a dispersion-stabilizing compound (DSC) according to Formulae VII, VIII, IX or X,

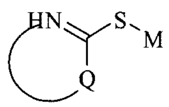

Formula VII

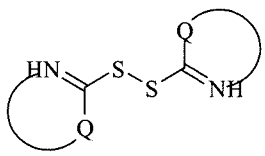

Formula VIII

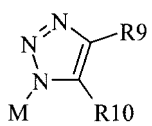

Formula IX

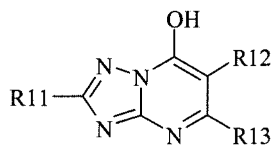

Formula X

wherein

Q represents the necessary atoms to form a substituted or unsubstituted five or six membered heteroaromatic ring;

M is selected from the group consisting of a proton, a monovalent cationic group, an alkyl group, a heteroalkylgroup and an acyl group;

R9 and R10 are independently selected from the group consisting of a hydrogen, a substituted or unsubstituted alkyl group, a substituted or unsubstituted alkenyl group, a substituted or unsubstituted alkynyl group, a substitued or unsubstituted alkaryl group, a substituted or unsubstituted aralkyl group, a substituted or unsubstituted aryl or heteroaryl group, a hydroxyl group, a thioether, an ether, an ester, an amide, an amine, a halogen, a ketone and an aldehyde;

R9 and R10 may represent the necessary atoms to form a five to seven membered ring;

R11 to R13 are independently selected from the group consisting of a hydrogen, a substituted or unsubstituted alkyl group, a substituted or unsubstituted alkenyl group, a substituted or unsubstituted alkynyl group, a substituted or unsubstituted alkaryl group, a substituted or unsubstituted aralkyl group, a substituted or unsubstituted aryl or heteroaryl group, a hydroxyl group, a thiol, a thioether, a sulfone, a sulfoxide, an ether, an ester, an amide, an amine, a halogen, a ketone, an aldehyde, a nitrile and a nitro group;

R12 and R13 may represent the necessary atoms to form a five to seven membered ring.

The dispersion-stabilizing compound is preferably a compound according to Formula VII.

The dispersion-stabilizing compound is more preferably a compound according to Formula VII, wherein Q represents the necessary atoms to form a five membered heteroaromatic ring.

A particular preferred dispersion-stabilizing compound is a compound according Formula VII, wherein Q is a five membered heteroaromatic ring selected from the group consisting of an imidazole, a benzimidazole, a thiazole, a benzothiazole, an oxazole, a benzoxazole, a 1,2,3-triazole, a 1,2,4-triazole, an oxadiazole, a thiadiazole and a tetrazole.

Some examples of dispersion-stabilizing compounds are shown in the following table.

| DSC | Chemical Formula |
|---|---|
| DCS-01 | 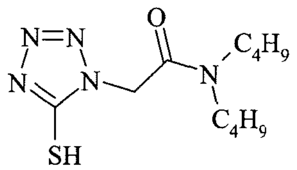 |
| DCS-02 | 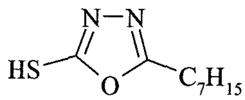 |
| DCS-03 | 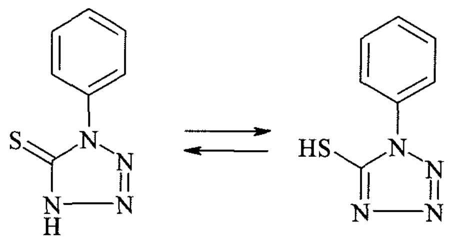 |
| DCS-04 | 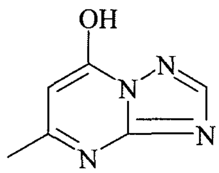 |
| DCS-05 | 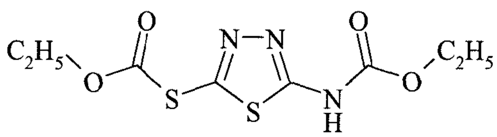 |
| DCS-06 | 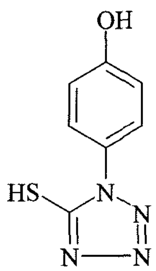 |

(continued)

| DSC | Chemical Formula |
|---|---|
| DCS-07 | 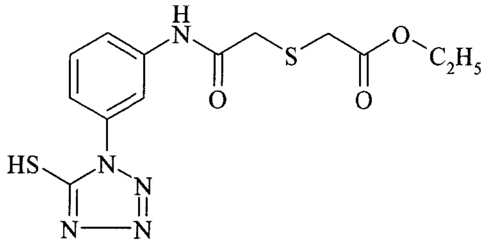 |
| DCS-08 | 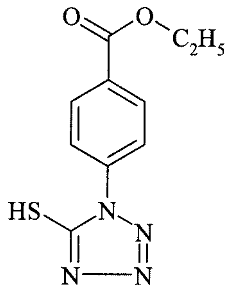 |
| DCS-09 | 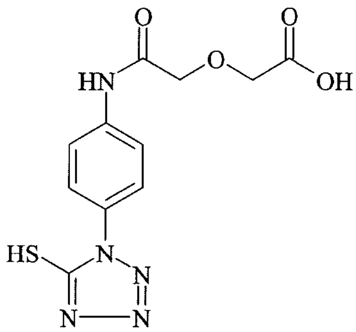 |
| DCS-10 | 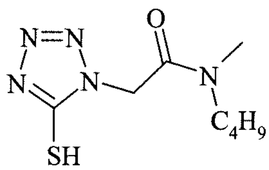 |
| DCS-11 | 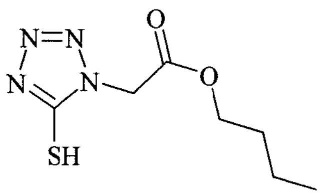 |
| DCS-12 | 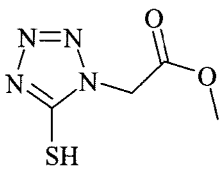 |

(continued)

| DSC | Chemical Formula |
|---|---|
| DCS-13 | 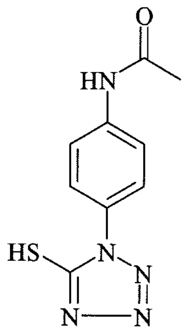 |
| DCS-14 | 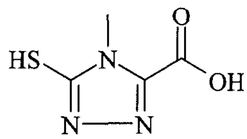 |
| DCS-15 | 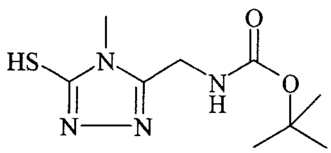 |
| DCS-16 | 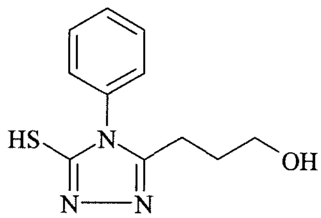 |

The dispersion-stabilizing compound is preferably selected from the group consisting of N,N-dibutyl-(2,5-dihydro-5-thioxo-1H-tetrazol-1-yl-acetamide, 5-heptyl-2-mercapto-1,3,4-oxadiazole, 1-phenyl-5-mercaptotetrazol, 5-methyl-1,2,4-triazolo-(1,5-a) primidine-7-ol, and S-[5-[(ethoxycarbonyl)amino]-1,3,4-thiadiazol-2-yl] O-ethyl thiocarbonate.

The dispersion-stabilizing compounds according to Formula VII to X are preferably non-polymeric compounds. Non-polymeric compounds as used herein means compounds having a Molecular Weight which is less preferably than 1000, more preferably less than 500, most preferably less than 350.

The amount of the dispersion-stabilizing compounds (DSC) expressed as wt % relative to the total weight of silver (Ag) in the metallic nanoparticles is preferably between 0.005 and 10.0, more preferably between 0.0075 and 5.0, most preferably between 0.01 and 2.5. When the amount of the dispersion-stabilizing compound relative to the total weight of silver in the metallic nanoparticles is too low, the stabilizing effect may be too low, while a too high amount of the dispersion-stabilizing compound may adversely affect the conductivity of the coating or patterns obtained with the metallic nanoparticle dispersion.

Polymeric dispersant

The metallic nanoparticle dispersion may contain a polymeric dispersant.

Polymeric dispersants typically contain in one part of the molecule so-called anchor groups, which adsorb onto the metallic particles to be dispersed. In another part of the molecule, polymeric dispersants have polymer chains compatible with the dispersion medium, also referred to as liquid vehicle, and all the ingredients present in the final printing or coating fluids.

Polymeric dispersants are typically homo- or copolymers prepared from acrylic acid, methacrylic acid, vinyl pyrrolidinone, vinyl butyral, vinyl acetate or vinyl alcohol monomers.

The polymeric dispersants disclosed in EP-A 2468827, having a 95 wt% decomposition at a temperature below 300°C as measured by Thermal Gravimetric Analysis may also be used.

However, in a preferred embodiment the metallic nanoparticle dispersion according to the present invention comprises less than 5 wt% of a polymeric dispersant relative to the total weight of the dispersion, more preferably less than 1 wt%, most preferably less than 0.1 wt%. In a particularly preferred embodiment the dispersion comprises no polymeric dispersant at all.

Additives

To optimize the coating or printing properties, and also depending on the application for which it is used, additives such as reducing agents, wetting/levelling agents, dewettting agents, rheology modifiers, adhesion agents, tackifiers, humectants, jetting agents, curing agents, biocides or antioxidants may be added to the metallic nanoparticle dispersion described above.

It may be advantageous to add to the metallic nanoparticle dispersion a small amount of an inorganic acid or a compound capable of generating such an acid during curing of a metallic layer or pattern formed from the metallic nanoparticle dispersion such as disclosed in EP-A 2821164. Higher conductivities and/or lower curing temperatures were observed of layers or patterns formed from such metallic nanoparticle dispersions.

Higher conductivities and/or lower curing temperatures may also be obtained when using metallic nanoparticles dispersions containing a compound according to Formula XI, as disclosed in WO2015/000937.

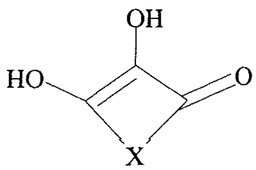

Formula XI

wherein

X represents the necessary atoms to form a a substituted or unsubstituted ring.

A particularly preferred compound according to Formula XI is an ascorbic or erythorbic acid derivative compound.

**Preparation of the metallic nanoparticle dispersion**

The preparation of the metallic nanoparticle dispersion typically comprises the addition of the liquid carrier, the vinylidene copolymer and optional additives to the metallic nanoparticles by using a homogenization technique such as stirring, high shear mixing, ultra-sonication, or a combination thereof.

The metallic nanoparticles from which the metallic nanoparticle dispersion is made is typically a paste or a highly concentrated dispersion of metallic nanoparticles. A preferred preparation method of the metallic nanoparticles is described below.

The homogenization step can be carried out at elevated temperature up to 100°C. In a preferred embodiment, the homogenization step is carried out at temperature equal or below 60°C.

In a preferred embodiment, the metallic nanoparticle dispersion is used in an inkjet printing method. Such a metallic nanoparticle dispersion, also referred to as metallic inkjet fluid or ink or conductive inkjet fluid or ink, preferably has a viscosity lower than 35 mPa.s, preferably lower than 28 mPa.s, and most preferably between 2 and 25 mPa.s at 25°C and measured at a shear rate of 90 $s^{-1}$.

When using so-called throughflow printheads, the viscosity of the metallic inkjet fluid may be higher, preferably below 60 mPa.s at 25°C and at a shear rate of 90 $s^{-1}$. A higher viscosity limit for the metallic inkjet fluid opens up more compositional variations of the fluid which may be advantageous towards more concentrated and/or more stable metallic inkjet fluids

In another preferred embodiment, the metallic nanoparticle dispersion is used in a flexographic printing process. Such a metallic nanoparticle dispersion, also referred to as metallic flexo ink or conductive flexo ink, preferably has a viscosity between 10 and 200 mPa.s, more preferably between 25 and 150 mPa.s, most preferably between 50 and 100 mPa.s measured at 25°C and at a shear rate of 90 $s^{-1}$.

In another preferred embodiment, the metallic nanoparticle dispersion is used in a screen printing process. Such a metallic nanoparticle dispersion, also referred to as metallic screen ink or conductive screen ink, preferably has a viscosity between 1000 and 500000 mPa.s, more preferably between 3000 and 100000 mPa.s, most preferably between 10000 and 50000 mPa.s measured at 25°C and at a shear rate of 1 $s^{-1}$.

## Metallic layers or patterns

Thin layers or patterns printed or coated from the metallic nanoparticle dispersion can be rendered conductive at lower sintering temperatures compared to those obtained with conventional metallic printing or coating fluids. Therefore, conductive thin layers or patterns made from the metallic printing or coating fluids of the present invention can be coated or printed on flexible supports that can not withstand thermal treatment at high temperature, such as for example PET.

The metallic layers or patterns are prepared by a method comprising the steps of applying a metallic nanoparticle dispersion as defined above on a support followed by a sintering step.

The support may be a glass or a polymeric support.

Preferred polymeric supports are polycarbonate, polyethylene terephthalate (PET) or polyvinylchloride (PVC) based supports. A preferred PET support is for example an AUTOSTAT™ heat stabilized polyester from MacDermid.

The above mentioned supports may be provided with one or more layers to improve the adhesion, absorption or spreading of the applied conductive inkjet, screen or flexo inks.

Polymeric supports are preferably provided with so-called subbing layers to improve the adhesion of the applied conductive inkjet, screen or flexo inks. Such subbing layers are typically based on vinylidene copolymers, polyesters, or (meth)acrylates.

Useful subbing layers for this purpose are well known in the art and include, for example, polymers of vinylidene chloride such as vinylidene chloride/acrylonitrile/ acrylic acid terpolymers or vinylidene chloride/methyl acrylate/itaconic acid terpolymers.

Other preferred subbing layers include a binder based on a polyester-urethane copolymer. In a more preferred embodiment, the polyester-urethane copolymer is an ionomer type polyester urethane, preferably using polyester segments based on terephthalic acid and ethylene glycol and hexamethylene diisocyanate. A suitable polyester-urethane copolymer is Hydran™ APX101 H from DIC Europe GmbH.

The application of subbing layers is well-known in the art of manufacturing polyester supports for silver halide photographic films. For example, the preparation of such subbing layers is disclosed in US 3649336 and GB 1441591.

In a preferred embodiment, the subbing layer has a dry thickness of no more than 0.2 $\mu$m or preferably no more than 200 mg/$m^2$.

In the method according to the invention the support is a glass or polymer support whereupon a layer of ITO (Indium Tin Oxide) is provided.

A paper based support is the Powercoat® paper substrate, a substrate designed for printed electronics by Arjowiggins Creative Papers.

Multiple metallic layers or patterns, i.e. a stack of patterned or unpatterned layers, may be applied on a substrate. The support referred to in the method of preparing the metallic layers or patterns thus also encompass a previously applied metallic layer or pattern.

Metallic layers may be provided onto a support by co-extrusion or any conventional coating technique, such as dip coating, knife coating, extrusion coating, spin coating, spray coating, blade coating, slot die coating, slide hopper coating and curtain coating.

Metallic layers and in particular metallic patterns may be provided onto a support by a printing method such as intaglio printing, screen printing, flexographic printing, offset printing, inkjet printing, gravure offset printing, etc.

Preferred printing methods are an inkjet, screen printing and flexographic printing method.

Another method to provide a metallic layer or pattern on a support is aerosol jet printing. Aerosol Jet Printing, which has been developed by Optomec, preserves most of the advantages of inkjet printing, while reducing many of its limitations. The technique is developed for use in the field of printed electronics. The technique is disclosed in for example US2003/0048314, US2003/0020768, US2003/0228124 and WO2009/049072. An Aerosol Jet Print Engine is commercially available from Optomec, for example the Aerosol Jet Printer OPTOMEC AJ 300 CE.

Virtually any liquid having a viscosity less than 5000 mPa.s can be deposited using the Aerosol Jet Printing technique. Using higher viscous fluids may be advantageous with respect to the stability of the metallic inks

## Curing Step

After the layers or patterns are applied on the support, a sintering step, also referred to as curing step, is carried out. During this sintering step, solvents evaporate and the metallic particles sinter together. Once a continuous percolating network is formed between the metallic particles, the layers or patterns become conductive. Conventional sintering is typically carried out by applying heat. The sintering temperature and time are dependent on the support used and on the composition of the metallic layer or pattern. The sintering step for curing the metallic layers may be performed at a temperature below 250°C, preferably below 200°C, more preferably below 180°C, most preferably below 160°C.

The sintering time may be less than 60 minutes, preferably between 2 and 30 minutes and more preferably between 3 and 20 minutes, depending on the selected temperature, support and composition of the metallic layers.

However, instead of or in addition to the conventional sintering by applying heat, alternative sintering methods such as exposure to an Argon laser, to microwave radiation, to UV radiation or to low pressure Argon plasma, photonic curing, plasma or plasma enhanced, electron beam, laser beam or pulse electric current sintering may be used. When using pulse electric current sintering, the electric current may be directly applied to the conductive ink or indirectly via induction.

Another curing method uses the so-called Near InfraRed (NIR) curing technology. The metal of the coating or the pattern, for example silver, may act as absorber for the NIR radiation.

The metallic layers of the present invention allow to use lower curing temperatures than the prior art processes. In consequence it is possible to use polymeric substrates that can not withstand thermal treatment at high temperature, such as for example PET. The curing time may also be substantially reduced leading to the possibility of having higher production per hour than the prior art processes. The conductivity of the metallic layers are maintained or even improved in certain cases.

To further increase the conductivity or to lower the curing temperature it may be advantageous to contact the metallic layer or pattern with a solution containing an acid or an acid precursor capable or releasing the acid during curing of the metallic layer or pattern, as disclosed in WO2015/000932.

The metallic layers or patterns may be used in various electronic devices or parts of such electronic devices as for example organic photo-voltaics (OPV' s), inorganic photo-voltaics (c-Si, a-Si, CdTe, CIGS), OLED displays, OLED lighting, inorganic lighting, RFID' s, organic transistors, thin film batteries, touch-screens, e-paper, LCD' s, plasma, sensors, membrane switches or electromagnetic shielding.

## Preparation of the metallic nanoparticles

The metallic nanoparticle may be prepared by any known preparation method.

A particularly preferred method to prepare the metallic nanoparticles is disclosed in EP-A 2781562.

The metallic nanoparticle dispersion obtained by the method disclosed in EP-A 2781562 typically contains at least 15 wt %, more preferably at least 30 wt%, most preferably at least 50 wt % of metallic nanoparticles, relative to the total weight of the dispersion. This highly concentrated dispersion is then used to prepare the metallic nanoparticle dispersion according to the present invention as described above.

# EXAMPLES

## Materials

All materials used in the following examples were readily available from standard sources such as ALDRICH CHEMICAL Co. (Belgium) and ACROS (Belgium) unless otherwise specified. The water used was deionized water.

**Silver oxide** ($Ag_2O$) was prepared by the precipitation of silver nitrate in an alkaline aqueous solution of sodium hydroxide (33 wt%) followed by filtration and drying.

**IXAN SGA-1,** a PVDC resin commercially available from SOLVAY.

**Dowanol DPMA** (CASRN 88917-22-0) is Dipropylene Glycol Methyl Ether Acetate commercially available from DOW CHEMICALS.

**2-octanone** (CASRN 111-13-7) is hexyl methyl ketone commercially available from Sigma-Aldrich.

**Diethylketon** (CASRN 96-22-0) is pentan-3-one diethyl ketone commericially available from Merck.

**Butyl Cellosolve** (CASRN 111-76-2) is etylene glycol monobutylether commerically available from Merck.

**Efka FL3277** (CASRN 849624-75-5) is a wetting agent commercially available from BASF.

**Byk 4511** is an adhesion promoting compound commercially available from Altana

**Byk 4510** is an adhesion promoting compound commercially available from Altana

## Measurements Methods

### Conductivity of the silver coatings

The surface resistance (SER) of the silver coatings was measured using a four-point collinear probe. The surface or sheet resistance was calculated by the following formula:

$$SER = (\pi / \ln 2) * (V/I)$$

wherein

SER is the surface resistance of the layer expressed in Ω/ ;
Π is a mathematical constant, approximately equal to 3.14;
ln2 is a mathematical constant equal to the natural logarithmic of value 2, approximately equal to 0.693;
V is voltage measured by voltmeter of the four-point probe measurement device;
I is the source current measured by the four-point probe measurement device.

For each sample, three measurements were performed at different positions of the coating and the average value was calculated.
The silver content $M_{Ag}$($g/m^2$) of the coatings was determined by WD-XRF.
The conductivity of the coated layers was then determined by calculating the conductivity as a percentage of the bulk conductivity of silver using the following formula:

$$\% Ag_{(bulk)} = \frac{\rho_{Ag} * \sigma_{Ag}}{M_{Ag} * SER} * 10^{-5} * 100\%$$

$$\% Ag_{(bulk)} = \frac{0.1663}{M_{Ag} * SER} * 100\%$$

wherein
$\rho_{Ag}$ is the density of silver (10.49 $g/cm^3$) and $\sigma_{Ag}$ the specific conductivity of silver (equal to 6.3 $10^5$ S/cm).

Adhesion

The adhesion of the silver coatings on different substrates has been evaluated by a tape test according to ASTM D3359. The evaluation results in a score from 0 (very good adhesion) to 5 (very bad adhesion).

**Example 1**

Preparation of the silver nanoparticle dispersion NPD-01

78.0 g of silver oxide was slowly added, while stirring, to a 1 l reactor containing 275.0 g of pentanoic acid and 401.0 g of 2-pyrrolidone. The temperature of the mixture was kept at 25°C.
After complete addition of the silver oxide, the suspension was stirred overnight at 25°C.
Then, 300.0 g of N,N-diethylhydroxylamine was added in a time span of 1.5 hours to the suspension. The temperature of the reaction mixture was kept at 25 °C. When all reducing agent was added, the reaction mixture was kept at 25 °C while stirring for another hour.
The reaction mixture is then fed to a sedimentation vessel, where it was kept overnight, without stirring. The supernatant was carefully removed from the sediment.
The obtained sediment was washed four times, two times with Dowanol PM™ (547 g) and two times with butylcellosolve™ (547 g). In each washing step, the solvent was added to the sediment and the resulting suspension stirred for 0.5 hour at 300 rpm. Then, the unstirred suspension was kept for another hour, and the supernatant carefully removed.
After the last washing step with butylcellosolve™, the sediment was centrifuged, in a centrifugal decanter from Rousselet Robatel (France) at 3000 rpm during 0.5 hour.
The obtained silver nanoparticle dispersion NPD-01 had ± 75 wt % of silver, relative to the total weight of the dispersion.

**Example 2**

Preparation of the silver inks SI-01 to SI-03

The Silver Inks SI-01 to SI-03 were prepared by mixing together while stirring the non-silver ingredients of Table 1 until a clear solution is obtained. The silver nanoparticle dispersion NPD-01 is then added to the clear solution, followed by high shear homogenization.

Table 1

| Ingredients (wt %) | SI-01 | SI-02 | SI-03 |
|---|---|---|---|
| IXAN SGA-1 | 2.30 | 2.30 | 2.30 |
| Diethylketon | 17.00 | - | - |
| 2-Octanone | - | 8.10 | 8.10 |
| Diacetonalcohol | 8.10 | - | - |
| Efka 3277 | 1.20 | 0.5 | 0.5 |
| Byk 4511 | - | 0.70 | - |
| Byk 4510 | - | - | 0.70 |
| NPD-01 | 71.40 | 71.40 | 71.40 |

The silver inks SI-01 to SI-03 were then coated on an ITO substrate (ITO layer on a 125 polyester support, commercially available from SKCHaas) at a wet coating thickness of 20 μm. The coated layer was dried during 3 minutes at 130°C in a belt oven and then cured during 15 minutes at 150°C. The conductivity (expressed as % Ag-bulk) and the adhesion on the ITO substrate were measured as described above. The results are shown in Table 2.

Table 2

| | [Ag] | Surfactant | Conductivity %Ag-bulk | Adhesion ITO |
|---|---|---|---|---|
| SI-01 | 56.5 | - | 25.2 | 2.8 |
| SI-02 | 56.5 | Byk 4511 | 27.0 | 2.0 |
| SI-03 | 56.5 | Byk 4510 | 23.0 | 0.5 |

The results of Table 2 clearly show that the presence of an acid polyester as adhesion promoting compound (SI-03) results in substantial improvement of the adhesion of the silver inks on ITO substrates compared with silver inks which do not contain an adhesion promoting compound (SI-01) or another type of adhesion promoting compound (SI-02).

## Claims

1. A method of preparing a silver layer or pattern comprising the step of applying a silver nanoparticle dispersion comprising silver nanoparticles, a liquid carrier and an adhesion promoting compound on a substrate followed by a sintering step, wherein the substrate is an ITO layer on a polymeric or glass support, **characterized in that** the adhesion promoting compound is an acidic polyester.

2. The method according to claim 1 wherein the acidic polyester has an acid value from 15 up to 150 mg KOH/g.

3. The method according to claim 1 or 2 wherein the acidic polyester is a branched polyester.

4. The method according to any of the preceding claims wherein the polyester is a polycondensate of trimethylolpropane and adipic acid.

5. The method according to any of the preceding claims wherein the amount of the acidic polyester is between 0.01 and 10.0 wt% relative to the total amount of the dispersion.

6. The method according to any of the preceding claims further comprising a binder, wherein the binder is a vinylidene chloride copolymer comprising 90 wt % or less of vinylidene chloride based on the total weight of the binder.

7. The method according to any of the preceding claims wherein the amount of the vinylidene copolymer is from 0.25 to 5.0 wt % relative to the total amount of the dispersion.

8. The method according to any of the preceding claims further comprising between 0.01 and 0.1 wt %, relative to the total weight of the dispersion, of an inorganic acid or a compound capable of generating such an acid during curing of a metallic layer or pattern formed from the metallic nanoparticle dispersion.

9. The method according to any of the preceding claims wherein the liquid carrier is a high boiling solvent (HBS).

10. The method according to claim 9 wherein the HBS is selected from the group consisting of 2-phenoxy-ethanol, propylene-carbonate, n-butanol, gamma-butyro-lactone, dimethylsulphoxide, 2-butoxyethanol, dipropylene glycol methyl ether acetate, methyl isobutyl keton, propylene glycol mono methyl ether acetate.

11. The method according to any of the preceding claims wherein the metallic nanoparticle dispersion is applied on the substrate by a printing method selected from intaglio printing, screen printing, flexographic printing, offset printing, inkjet printing, or gravure offset printing.

12. The method according to any of the preceding claims wherein the sintering is carried out at a temperature of 200°C or less during 30 minutes or less.

13. The method according any of the preceding claims wherein the sintering is carried out by heat or photonic or NIR curing.

**Patentansprüche**

1. Ein Verfahren zur Herstellung einer Silberschicht oder eines Silbermusters, umfassend den Schritt, in dem eine Silbernanopartikeldispersion, die Silbernanopartikel, einen flüssigen Träger und eine haftungsfördernde Verbindung enthält, auf ein Substrat aufgetragen wird und anschließend ein Sinterungsschritt erfolgt, wobei das Substrat eine auf einen Polymer- oder Glasträger aufgebrachte ITO-Schicht ist, **dadurch gekennzeichnet, dass** die haftungsfördernde Verbindung ein saurer Polyester ist.

2. Das Verfahren nach Anspruch 1, wobei der Säurewert des sauren Polyesters zwischen 15 und 150 mg KOH/g liegt.

3. Das Verfahren nach Anspruch 1 oder 2, wobei der saure Polyester ein verzweigter Polyester ist.

4. Das Verfahren nach einem der vorstehenden Ansprüche, wobei der Polyester ein Polykondensat von Trimethylolpropan und Adipinsäure ist.

5. Das Verfahren nach einem der vorstehenden Ansprüche, wobei die Menge des sauren Polyesters zwischen 0,01 und 10,0 Gew.-%, bezogen auf die Gesamtmenge der Dispersion, liegt.

6. Das Verfahren nach einem der vorstehenden Ansprüche, das ferner ein Bindemittel enthält, wobei das Bindemittel ein Vinylidenchloridcopolymer ist, das 90 Gew.-% oder weniger Vinylidenchlorid, bezogen auf das Gesamtgewicht des Bindemittels, enthält.

7. Das Verfahren nach einem der vorstehenden Ansprüche, wobei die Menge des Vinylidencopolymers zwischen 0,25 und 5,0 Gew.-%, bezogen auf die Gesamtmenge der Dispersion, liegt.

8. Das Verfahren nach einem der vorstehenden Ansprüche, ferner enthaltend zwischen 0,01 und 0,1 Gew.-%, bezogen auf das Gesamtgewicht der Dispersion, einer anorganischen Säure oder einer Verbindung, die in der Lage ist, während der Härtung einer aus der Metallnanopartikeldispersion gebildeten Metallschicht oder eines aus der Metallnanopartikeldispersion gebildeten Metallmusters eine solche Säure zu erzeugen.

9. Das Verfahren nach einem der vorstehenden Ansprüche, wobei der flüssige Träger ein hochsiedendes Lösungsmittel (HBS) ist.

10. Das Verfahren nach Anspruch 9, wobei das HBS aus der Gruppe bestehend aus 2-Phenoxyethanol, Propylencarbonat, n-Butanol, gamma-Butyrolacton, Dimethylsulfoxid, 2-Butoxyethanol, Dipropylenglycolmethyletheracetat, Methylisobutylketon und Propylenglycolmonomethyletheracetat ausgewählt wird.

**11.** Das Verfahren nach einem der vorstehenden Ansprüche, wobei die Metallnanopartikeldispersion gemäß einem Druckverfahren, ausgewählt aus Tiefdruck, Siebdruck, Flexodruck, Offsetdruck, Tintenstrahldruck oder Offsettiefdruck, auf das Substrat aufgetragen wird.

**12.** Das Verfahren nach einem der vorstehenden Ansprüche, wobei die Sinterung bei einer Temperatur von 200°C oder weniger über einen Zeitraum von 30 Minuten oder weniger vorgenommen wird.

**13.** Das Verfahren nach einem der vorstehenden Ansprüche, wobei die Sinterung durch Erwärmung oder photonische Härtung oder NIR-Härtung erfolgt.

## Revendications

**1.** Procédé de préparation d'une couche d'argent ou d'une structure d'argent comprenant l'étape consistant à appliquer une dispersion de nanoparticules d'argent contenant des nanoparticules d'argent, un véhicule liquide et un composé promoteur de l'adhésion sur un substrat et à effectuer ensuite une étape de frittage, ledit substrat étant une couche d'ITO appliquée sur un support polymère ou un support de verre, **caractérisé en ce que** le composé promoteur de l'adhésion est un polyester acide.

**2.** Procédé selon la revendication 1, **caractérisé en ce que** l'indice d'acide du polyester acide est compris entre 15 et 150 mg KOH/g.

**3.** Procédé selon la revendication 1 ou 2, **caractérisé en ce que** le polyester acide est un polyester ramifié.

**4.** Procédé selon l'une quelconque des revendications précédentes, **caractérisé en ce que** le polyester est un polycondensat de triméthylolpropane et d'acide adipique.

**5.** Procédé selon l'une quelconque des revendications précédentes, **caractérisé en ce que** la quantité du polyester acide est comprise entre 0,01 et 10,0% en poids par rapport à la quantité totale de la dispersion.

**6.** Procédé selon l'une quelconque des revendications précédentes, comprenant en outre un liant, ledit liant étant un copolymère de chlorure de vinylidène contenant 90% ou moins de chlorure de vinylidène par rapport au poids total du liant.

**7.** Procédé selon l'une quelconque des revendications précédentes, **caractérisé en ce que** la quantité du copolymère de vinylidène est comprise entre 0,25 et 5,0% en poids par rapport à la quantité totale de la dispersion.

**8.** Procédé selon l'une quelconque des revendications précédentes, contenant en outre entre 0,01 et 0,1% en poids par rapport au poids total de la dispersion d'un acide inorganique ou d'un composé capable de générer un tel acide lors du durcissement d'une couche ou structure métallique formée à partir de la dispersion de nanoparticules métalliques.

**9.** Procédé selon l'une quelconque des revendications précédentes, **caractérisé en ce que** le véhicule liquide est un solvant à point d'ébullition élevé (HBS).

**10.** Procédé selon la revendication 9, **caractérisé en ce que** l'HBS est choisi parmi le groupe composé de 2-phénoxyéthanol, de carbonate de propylène, de n-butanol, de gamma-butyrolactone, de diméthylsulfoxyde, de 2-butoxyéthanol, d'acétate d'éther méthylique de dipropylène glycol, de méthylisobutylcétone et d'acétate d'éther monométhylique de propylène glycol.

**11.** Procédé selon l'une quelconque des revendications précédentes, **caractérisé en ce que** la dispersion de nanoparticules métalliques est appliquée sur le substrat selon un procédé d'impression choisi parmi l'impression en héliogravure, la sérigraphie, l'impression flexographique, l'impression offset, l'impression à jet d'encre ou l'impression ou l'impression offset-héliogravure.

**12.** Procédé selon l'une quelconque des revendications précédentes, **caractérisé en ce que** le frittage s'effectue à une température de 200°C ou moins en 30 minutes ou moins.

13. Procédé selon l'une quelconque des revendications précédentes, **caractérisé en ce que** le frittage s'effectue par chauffage ou par durcissement photonique ou par durcissement NIR.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 2010143591 A
- US 2009142482 A
- US 20060264518 A
- EP 2147733 A
- EP 2139007 A
- EP 803551 A
- EP 2012952 A
- EP 2030706 A
- EP 1683592 A
- EP 166617 A
- EP 2119747 A
- EP 2087490 A
- EP 2010314 A
- WO 2008151066 A
- WO 2006076603 A
- WO 2009152388 A
- WO 2009157393 A
- EP 2468827 A
- EP 2608218 A
- EP 2608217 A
- EP 2671927 A
- EP 2781562 A
- EP 1860163 A
- WO 2004069941 A
- WO 2015023370 A
- US 2004144958 A
- EP 2746353 A
- WO 2012162301 A
- EP 2821164 A
- WO 2015000937 A
- US 3649336 A
- GB 1441591 A
- US 20030048314 A
- US 20030020768 A
- US 20030228124 A
- WO 2009049072 A
- WO 2015000932 A


### Non-patent literature cited in the description


- Approaches to the synthesis and Characterization of Spherical and Anisotropic Silver Nanomaterials. Metallic Nanomaterials. Wiley-VGH Verlag GmbH&Co.KGaA, vol. 1
- *CHEMICAL ABSTRACTS,* 88917-22-0
- *CHEMICAL ABSTRACTS,* 111-13-7
- *CHEMICAL ABSTRACTS,* 96-22-0
- *CHEMICAL ABSTRACTS,* 111-76-2
- *CHEMICAL ABSTRACTS,* 849624-75-5